**Europäisches Patentamt**

**European Patent Office**

**Office européen des brevets**

(11) Veröffentlichungsnummer: **0 410 401 A1**

# EUROPÄISCHE PATENTANMELDUNG

(21) Anmeldenummer: **90114215.8**

(22) Anmeldetag: **25.07.90**

(51) Int. Cl.5: **C23C 14/04**, C23C 16/04

(30) Priorität: **28.07.89 DE 3925085**

(43) Veröffentlichungstag der Anmeldung:
**30.01.91 Patentblatt 91/05**

(84) Benannte Vertragsstaaten:
**FR GB IT**

(71) Anmelder: **Battelle-Institut e.V.**
**Am Römerhof 35 Postfach 900 160**
**D-6000 Frankfurt/Main 90(DE)**

(72) Erfinder: **Stafast, Herbert, Dr.**
**Pfingstbornstrasse 89**
**D-6200 Wiesbaden(DE)**
Erfinder: **Dunin von Przychowski, Michael**
**Steinbacher Strasse 21**
**D-6242 Kronberg 2(DE)**
Erfinder: **Chu, Wing Fong, Dr.**
**Falkensteiner Strasse 61**
**D-6000 Frankfurt am Main 1(DE)**

(54) **Verfahren zum Beschichten einer Substratfläche.**

(57) Eine Vorrichtung zum Beschichten einer Substratfläche (4) mit einer Einrichtung zum Erzeugen einer Gasphase in einer Kammer (1) und mit einem Aktivierungslaser (10) weist erfindungsgemäß eine Maske (11) im Strahlengang des Aktivierungslasers (10) auf. Damit kann eine entsprechend flächig strukturierte Beschichtung (12) auf dem Substrat (1) erzeugt werden.

Die Vorrichtung wird insbesondere zur Herstellung einer dünnen Beschichtung (12) aus keramischem Material auf dem Substrat (4) eingesetzt, insbesondere zur Herstellung von integrierten Schaltungen oder Hochtemperatur-Supraleitern.

FIG. 1

EP 0 410 401 A1

## VORRICHTUNG ZUM BESCHICHTEN EINER SUBSTRATFLÄCHE

Die Erfindung betrifft eine Vorrichtung zum Beschichten einer Substratfläche mit einer Kammer, einer Einrichtung zum Erzeugen einer Gasphase aus einem auf der Substratfläche abzuscheidenden Material und mit einem Aktivierungslaser, der die zu beschichtende Substratfläche bestrahlt.

Zum Beschichten eines Substrats gibt es zahlreiche bekannte Verfahren. Beispielsweise wird das zu beschichtende Material mit Hilfe eines Plasma-CVD-Prozesses auf der Substratfläche abgeschieden.

Bei jedem der bekannten Beschichtungsverfahren müssen die dem betreffenden Beschichtungsverfahren eigenen Verfahrensparameter in den jeweils gegebenen Grenzen relativ genau eingehalten werden. Die eigentliche Beschichtung kann man zusätzlich gegebenenfalls beispielsweise eine entsprechende Erwärmung der zu beschichtenden Substratfläche unterstützen. Eine solche Erwärmung ist aber in vielen Fällen nachteilig, weil dadurch wiederum die Auswahl der Materialien des Substrats und auch der Beschichtung in weiten Grenzen eingeschränkt werden.

Es ist auch das sogenannte Laserschreiben bekannt, wobei das Licht eines Lasers auf eine Oberfläche gerichtet wird und lokal Material aus einer die Oberfläche umgebenden Gasphase aktiviert, wodurch dort lokal eine Beschichtung erzeugt wird. Ganz ähnlich wie bei den vorstehend beschriebenen Beschichtungsverfahren ist aber auch hier nur eine einzige Energiequelle vorhanden, nämlich der Laser, der sowohl die die Beschichtung aufbauenden Teilchen erzeugt als auch die Substratoberfläche aktiviert. Auch bei diesen bekannten Verfahren muß man die Verfahrensparameter daher verhältnismäßig eng aufeinander abstimmen, was für viele Anwendungsfälle nachteilig ist.

Hier hat die DE-OS 33 03 084 bereits Abhilfe geschaffen, als dort schon zur Erzeugung von Hartstoffschichten eine Substratoberfläche mit einem oder mehreren Lasern bestrahlt wird. Der Betrieb der beiden Laser ist grundsätzlich voneinander unabhängig. Von diesem Stand der Technik geht die Erfindung aus. Dort wird aber das Substrat mit dem Laserstrahl abgerastert. Dies bedingt aber den Nachteil, daß das von dem sich bewegenden Laserstrahl gerade verdampfte Substratmaterial auf der vorher behandelten Spur abscheiden kann, wodurch dort die Zusammensetzung verfälscht wird.

Einen ähnlichen Stand der Technik beschreibt die GB-A 20 75 555, wo eine zu beschichtende Substratfläche mit Hilfe eines Impulslasers angeschmolzen wird. Dies ist aber nachteilig, weil die angeschmolzene Fläche sich nicht für die Herstellung von integrierten Schaltungen, Supraleitern usf. eignet. Auch ist dort keine Strukturierung der Beschichtung vorgesehen.

Der EP-A2-0 306 069 kann die Lehre entnommen werden, mittels fotolytischer Dissoziation von gasförmigem Sauerstoff auf einer Substratfläche abzuscheiden. Bedingt durch die Diffusion der Sauerstoff-Gasteilchen wird aber auch hier die erzeugte räumliche Struktur sehr unscharf.

Ausgehend von einer Vorrichtung mit den eingangs genannten Merkmalen liegt der Erfindung daher die Aufgabe zugrunde, diese so auszugestalten, daß mit ihr eine flächig strukturierte Beschichtung auf dem Substrat erzeugt werden kann.

Zur Lösung dieser Aufgabe ist die Erfindung dadurch gekennzeichnet, daß im Strahlengang des Aktivierungslasers eine Maske angeordnet ist.

Dadurch kann man eine entsprechend flächig strukturierte Beschichtung auf dem Substrat erzeugen. Dies ist bei zahlreichen Anwendungsfällen von Vorteil, beispielsweise bei der Herstellung einer dünnen Beschichtung aus keramischem Material, insbesondere von integrierten Schaltungen und Hochtemperatur-Supraleitern, auf welche Gebiete die Erfindung daher vorzugsweise angewendet wird.

Mit Hilfe von an sich bekannten Verfahren stellt man somit in der Kammer die Gasphase aus dem Schichtmaterial her, wobei die Parameter dieser ersten Verfahrensstufe an die jeweiligen Gegebenheiten optimal angepaßt werden können. Hierfür werden weiter unten und in den Unteransprüchen 2 bis 5 bevorzugte Beispiele gegeben.

Nachdem die Erzeugung der Gasphase aus dem Beschichtungsmaterial in der Kammer erfolgt ist, ist die eigentliche Abscheidung des Materials aus der Gasphase in ihren Abscheidungsparametern abermals unabhängig von den Verfahrensparametern für die Erzeugung der Gasphase in der Kammer, weil die Abscheidung über den Aktivierungslaser erfolgt, der die betreffende Substratfläche entsprechend aktiviert, so daß über dort lokal über den Aktivierungslaser zugeführte Aktivierungsenergie die Abscheidung der Beschichtung bzw. des Films erfolgt. Mit anderen Worten erfolgt die Erzeugung der Gasphase aus dem Beschichtungsmaterial getrennt von der Aktivierung der Substratfläche derart, daß dort aus der Gasphase die Beschichtung erfolgt. Man kann beide Sätze von Prozeßparametern daher weitgehend voneinander unabhängig wählen und auf die jeweiligen Verhältnisse optimieren. Beide Prozeßparamtersätze sind voneinander entkoppelt. Es sei erwähnt, daß der Aktivierungslaser das Substratmaterial bis zu einer vorgegebenen, geringen Tiefe aktiviert derart, daß dort - auch flächig lokal - diejenigen Bedingungen geschaffen werden, daß sich das Material der Gasphase dort abscheidet und die Beschichtung bildet.

Ein wesentlicher Vorteil der erfindungsgemäßen Vorrichtung liegt darin, daß der Aktivierungslaser ausreichend Energie an die zu beschichtende Oberfläche abgibt, so daß diese nicht unbedingt auf eine hohe Temperatur erwärmt werden muß. Die zu beschichtende Substratfläche kann auch entsprechend hoch erwärmt werden. Dies ist nun bei zahlreichen Anwendungsfällen nicht mehr notwendig oder doch nicht mehr auf die bisher notwendigen und verhältnismäßig hohen Temperaturen, die das Einsatzgebiet derartiger bekannter Beschichtungsverfahren fühlbar eingeschränkt haben. Wenn man beispielsweise das Substrat auf eine Temperatur von etwa 400° C erwärmt, so wird dadurch die Abscheidung bei einer Reihe von Anwendungsfällen positiv unterstützt, ohne daß diese verhältnismäßig milde Erwärmung die Anwendungsgebiete des erfindungsgemäßen Verfahrens fühlbar einschränkt. Gegebenenfalls kann sogar auf jegliche Zusatzerwärmung vollständig verzichtet werden.

Die Erfindung wird im folgenden anhand von Ausführungsbeispielen näher erlautert. Es zeigt:

Fig. 1 - schematisch eine Vorrichtung, bei der das abzuscheidende Material mit Hilfe eines Verdampfungslasers in die Gasphase überführt wird;

Fig. 2 - ein Ausführungsbeispiel, bei dem die Gasphase einem Plasma-CVD-Prozeß unterworfen ist;

Fig. 3 - ein Ausführungsbeispiel, bei dem das Material laserchemisch aus der Gasphase abgeschieden wird,

Fig.4. - ein Ausführungsbeispiel, bei dem das Material thermisch verdampft wird.

Bei allen Ausführungsbeispielen erfolgt die Aktivierung des in der Gasphase bzw. im Plasma vorhandenen Materials mittels eines Aktivierungslasers.

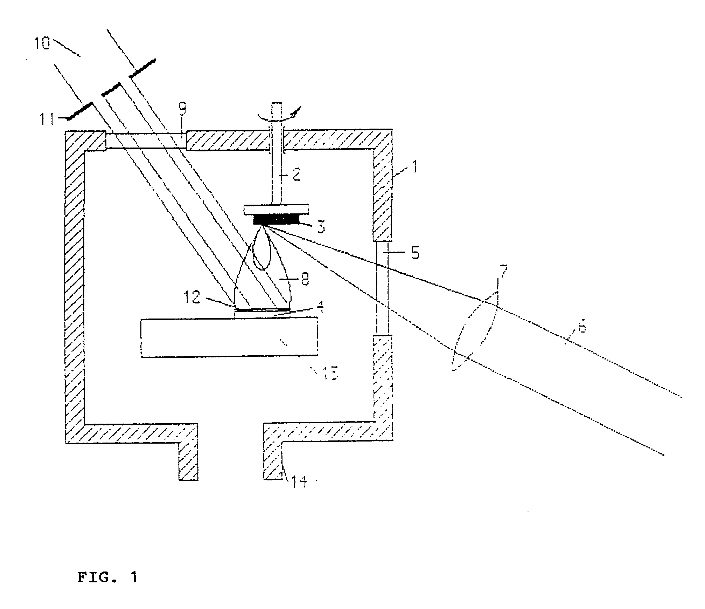

In Fig. 1 ist eine Kammer 1 vorgesehen, in der ein drehbar gelagerter Halter 2 für ein Target 3 aus einem Material gehalten ist, mit den ein Substrat 4 beschichtet werden soll. Das Material des Targets ist vorzugsweise gesintert.

Über ein in der Kammerwand vorgesehenes Fenster 5 wird hierzu ein Verdampfungslaser, dessen Strahlenbündel bei Pos. 6 angedeutet ist, auf das Target 3 gerichtet. Eine bei Pos. 7 angedeutete Linse erzeugt einen Brennpunkt des Verdampfungslasers auf der Oberfläche des Targets 3.

Der Verdampfungslaser ist vorzugsweise als Excimerlaser ausgebildet, was bei aus unterschiedlichen Substanzen zusammengesetzten Targets den Vorteil mit sich bringt, daß der Excimerlaser die unterschiedlichen Substanzen in gleichen Anteilen verdampft. In Fig. 1 ist eine Keule 8 angedeutet, die darlegt, daß das Material als Plasma aus dem Target herausgeschleudert und im wesentlichen auf das Substrat 4 gerichtet wird.

Über ein weiteres Fenster 9 in der Kammerwand bestrahlt ein Aktivierungslaser 10 die Oberfläche des Substrats. Im Strahlengang des Lasers ist eine Maske 11 angeordnet. Bei Pos. 12 ist die mit dieser Verfahrensführung hergestellte Beschichtung angedeutet, die entsprechend der Struktur der Maske 11 ebenfalls strukturiert ist.

Der Halter 2 kann drehbar sein, um das Material des Targets 3 möglichst vollständig ausnutzen zu können. Aus diesem Grunde kann der Lichtstrahl des Lasers 6 entsprechend verstellt werden. Außerdem ist eine Heizung 13 gezeigt, die das Substrat 4 ggf. erwärmt. Über einen Stutzen 14 ist die Kammer an eine Vakuumpumpe angeschlossen, die den notwendigen Unterdruck in der Kammer erzeugt.

Bei einem speziellen Anwendungsfall wird mit Hilfe des Excimerlasers 6 Targetmaterial $YBa_2Cu_3O_{7-x}$ verdampft und die Substratoberfläche wird gleichzeitig mit einem $CO_2$-Dauerstrichlaser als Aktivierungslaser 10 bestrahlt.

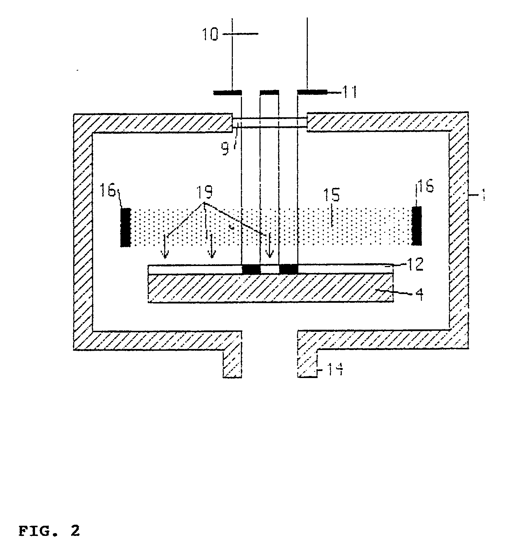

In Fig. 2 ist eine lokalisierte Aktivierung der Substratoberfläche mit dem Aktivierungslaser 10 vorgesehen, und zwar während eines Plasma-CVD-Prozesses, der ein Plasma 15 zwischen Elektroden 16 erzeugt. In der Kammer 1 befindet sich das Reaktionsgas. Ein Plasma-CVD-Prozeß ist eine plasmaunterstützte, chemische Abscheidung aus der Gasphase.

Das Ausführungsbeispiel Fig. 2 zeigt im übrigen, daß das Substrat auf seiner ganzen, dem Plasma 15 zugewandten Oberfläche beschichtet werden kann. Die Beschichtung durch den Aktivierungslaser 10 hat aber andere Eigenschaften als die Beschichtung in den nicht vom Laser 10 aktivierten Bereichen.

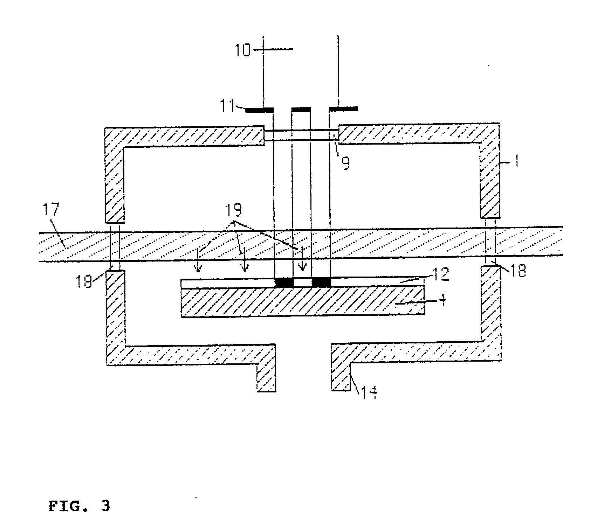

Fig. 3 zeigt ein Ausführungsbeispiel, wobei die Substratoberfläche ebenfalls mit Hilfe des Aktivierungslasers 10 aktiviert wird, wobei auch hier eine Maske 11 vorgesehen sein kann. Ein weiterer Laser 17 ist in Fig. 3 vorgesehen, der über Fenster 18 das Innere der Kammer 1 durchstrahlt und das dort vorhandene Reaktionsgas, welches vorher in die Kammer eingeführt wurde, aus der Gasphase laserchemisch abscheiden läßt, wie durch die Pfeile 19 angedeutet.

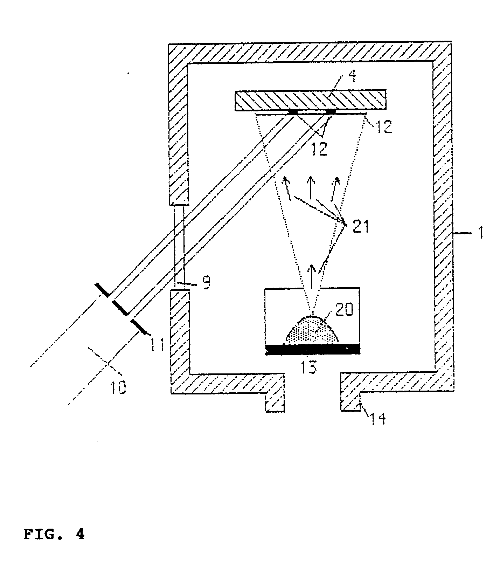

Beim Ausführungsbeispiel nach Fig. 4 ist die Heizung so ausgebildet, daß das zu beschichtende Material 20 verdampft, wie durch die Pfeile 21 angedeutet. Auch hier wird über die Verdampfung somit eine Gasphase erzeugt und der Aktivierungslaser 10, ggf. mit seiner Maske 11, aktiviert die Substratoberfläche lokal, wodurch in den entsprechenden Gebieten lokal die Beschichtung 12 hergestellt wird.

Die erfindungsgemäße Vorrichtung bietet besondere Vorteile für die Herstellung dünner Filme aus Keramiken. Derartige dünne Filme oder Beschichtungen haben ein großes technisches Potential, beispielsweise für integrierte Schaltungen, als Isolierschichten, Kondensatoren, Sensoren, Katalysatoren, Festkörperelektrolyte und zur Oberflächenvergütung. Unter diesen Materialien nehmen die Hochtemperatur-Supraleiter eine besondere Stellung ein.

Durch die erfindungsgemäße Vorrichtung ist es möglich, die Beschichtung mit einer glatten Oberfläche mit einem scharfen Übergang zum Substratmaterial zu versehen. Die Beschichtung hat die jeweils gewünschte, korrekte Zusammensetzung, Kristallstruktur und Stöchiometrie. Dadurch werden im Fall der Hochtemperatur-Supraleiter eine hohe Sprungtemperatur (Widerstand = Null) und eine schmale Temperaturbreite (< $1°K$) erzielt. Außerdem kann man eine bevorzugte Orientierung der Kristalle im Film erreichen. Im Falle der Hochtemperatur-Supraleiter liegt die Orientierungsrichtung vorzugsweise in der C-Achse der Kristalle senkrecht zur Substratoberfläche. Dadurch wird eine hohe kritische Stromdichte $>10^5$ A/cm$^2$ erzielt.

Die in Zusammenhang mit Fig. 1 beschriebene Vorrichtung, wobei man über den Verdampfungslaser 6 eine gepulste Laserverdampung einsetzt, hat besondere Vorteile, weil danach das verdampfte Targetmaterial nur lokal erhitzt wird. Das Targetmaterial und die Halterung werden also schonend behandelt. Die chemische Zusammensetzung des Targetmaterials bleibt während und nach dem Prozeß erhalten. Es erfolgt keine nennenswerte Entmischung der Substanzen: Die abgeschiedene Schicht hat die gleiche Zusammensetzung wie das Quellmaterial.

Nach der Beschichtung ist keine anschließende Wärmebehandlung mehr erforderlich. Vielmehr wird die Substratoberfläche lokal aktiviert. Die tiefer liegenden Substratschichten können zur Verhinderung von Ionendiffusion oder thermischer Zersetzung auf tiefer Temperatur gehalten werden, z.B. auf etwa $400°$C im Fall von $YBa_2Cu_3O_{7-x}$.

Die abgeschiedene Dünnschicht zeichnet sich durch eine gute Qualität aus. Mit dem Aktivierungslaser als zusätzliche Energiequelle kann infolge der lokalisierten Oberflächenaktivierung zugleich die Schicht schon während des Wachstums in der Substratebene strukturiert werden.

## Ansprüche

1. Vorrichtung zum Beschichten einer Substratfläche mit einer Kammer, einer Einrichtung zum Erzeugen einer Gasphase aus einem auf der Substratfläche abzuscheidenden Material und mit einem Aktivierungslaser, der die zu beschichtende Substratfläche bestrahlt,

**dadurch gekennzeichnet,**
daß im Strahlengang des Aktivierungslasers (10) eine Maske (11) angeordnet ist.

2. Vorrichtung nach Anspruch 1,
**dadurch gekennzeichnet,**
daß die Einrichtung (6) als Verdampfungslaser, vorzugsweise als Excimerlaser, ausgebildet ist, der auf ein mit dem Material beschichtetes Target (3) gerichtet ist.

3. Vorrichtung nach Anspruch 1,
**dadurch gekennzeichnet,**
daß die Einrichtung in der Kammer (1) einen Plasma-CVD-Prozeß erzeugt.

4. Vorrichtung nach Anspruch 1,
**dadurch gekennzeichnet,**
daß die Einrichtung das abzuscheidende gasförmige Material laserchemisch aktiviert.

5. Vorrichtung nach Anspruch 1,
**dadurch gekennzeichnet,**
daß die Einrichtung das abzuscheidende Material in der Kammer thermisch verdampft und in die Gasphase überführt.

6. Anwendung der Vorrichtung nach einem der Ansprüche 1 bis 5 auf die Herstellung einer dünnen Beschichtung aus keramischem Material, insbesondere von integrierten Schaltungen und Hochtemperatur-Supraleitern.

FIG. 1

FIG. 2

FIG. 3

**FIG. 4**

**Europäisches Patentamt**

**EUROPÄISCHER RECHERCHENBERICHT**

Nummer der Anmeldung

EP 90114215.8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
|---|---|---|---|
| A | DE - A1 - 2 706 845<br>(UNITED TECHNILOGIES)<br>* Ansprüche 1,3 *<br>-- | 1 | C 23 C 14/04<br>C 23 C 16/04 |
| A | DE - A1 - 3 011 022<br>(ROLLS ROYCE)<br>* Ansprüche 1,7 *<br>-- | 1 | |
| D,A | DE - A1 - 3 303 084<br>(VEB HOCHVAKUUM)<br>* Zusammenfassung *<br>-- | 1 | |
| D,A | EP - A2 - 0 306 069<br>(NV PHILIPS GLOEILLAMPENFA-<br>BRIEKEN)<br>* Zusammenfassung *<br>-- | 1 | |
| A | US - A - 4 746 548<br>(BOUDREAU et al.)<br>* Zusammenfassung *<br>---- | 1 | |

**RECHERCHIERTE SACHGEBIETE (Int. Cl.⁵)**

C 23 C

Der vorliegende Recherchenbericht wurde für alle Patentansprüche erstellt.

| Recherchenort | Abschlußdatum der Recherche | Prüfer |
|---|---|---|
| WIEN | 25-10-1990 | WILFLINGER |